# EUROPEAN PATENT APPLICATION

(11) **EP 2 063 461 A1**
(43) Date of publication of application: **27.05.2009**
(21) Application number: 07807012.5
(22) Date of filing: 10.09.2007
(51) Int. Cl.: H01L 21/304, B24B 37/00, C09K 3/14

(54) **POLISHING AGENT FOR SEMICONDUCTOR INTEGRATED CIRCUIT DEVICE, POLISHING METHOD, AND METHOD FOR MANUFACTURING SEMICONDUCTOR INTEGRATED CIRCUIT DEVICE**

(30) Priority: 13.09.2006 JP 2006248220
(71) Applicant: Asahi Glass Company, Limited, Chiyoda-ku Tokyo 100-8405 (JP)
(72) Inventor: KON, Yoshinori, Tokyo; 100-8405 (JP); YOSHIDA, Iori, Tokyo; 100-8405 (JP)
(74) Representative: Müller-Boré & Partner Patentanwälte
(86) International application number: PCT/JP2007/067602
(87) International publication number: WO 2008/032681

(57) **Abstract**

An object of the present invention is to provide a polishing agent for a semiconductor, which is used for polishing a to-be-polished surface of a silicon dioxide-based material layer in the production of a semiconductor integrated circuit device and which is excellent in the dispersion stability and produces less defects such as scratch and has excellent planarization characteristics in polishing. In the present invention, at the production of a semiconductor integrated circuit device, in the case where the to-be-polished surface is a to-be-polished surface of a silicon dioxide-based material layer, the polishing agent for chemical mechanical polishing used when polishing the to-be-polished surface is a polishing agent comprising a cerium oxide particle, a water-soluble polyether amine, at least one substance selected from the group consisting of a polyacrylic acid and a salt thereof, and water, wherein the pH of the polishing agent is from 6 to 9 and the substance above is contained in an amount of more than 0.02 mass% based on the entire mass of the polishing agent.

## Description

### TECHNICAL FIELD

The present invention relates to a polishing technique used in a production step of a semiconductor integrated circuit device. More specifically, the present invention relates to a polishing technique used in a production step of a semiconductor integrated circuit device containing a silicon dioxide-based material layer.

### BACKGROUND ART

With the recent progress toward higher integration and higher functionality of a semiconductor integrated circuit device, development of a microfabrication technique for realizing refinement and high density is demanded. In particular, the importance of a planarizing technique by a chemical mechanical polishing method (hereinafter referred to as "CMP") has been rising.

For example, as the refinement of a semiconductor integrated circuit device or multi-layering of wiring advances, unevenness (difference in level) on the surface of each layer in the production step tends to become great. For preventing a problem that this difference in level exceeds the focal depth of photolithography, thereby failing to obtain sufficiently high resolution, the CMP has been an indispensable technique.

Also, for a conventional semiconductor device, a selective thermal oxidation method of a silicon substrate, called a LOCOS (Local Oxidation of Silicon) method, has been used for electrical separation between elements such as transistor. However, this technique has a problem that the separated region formed by thermal oxidation generates unevenness on the surface due to volume expansion. In addition, there is a problem that oxidation proceeds in the transverse direction to intrude into the element region, which stands as an obstacle to the refinement. Accordingly, in recent years, a method of separating elements by a shallow trench (Shallow Trench Isolation, hereinafter referred to as "STI") has being introduced. This is a technique in which a trench is provided on a silicon substrate to electrically insulate element regions and an insulation film such as silicon oxide film is embedded in the trench.

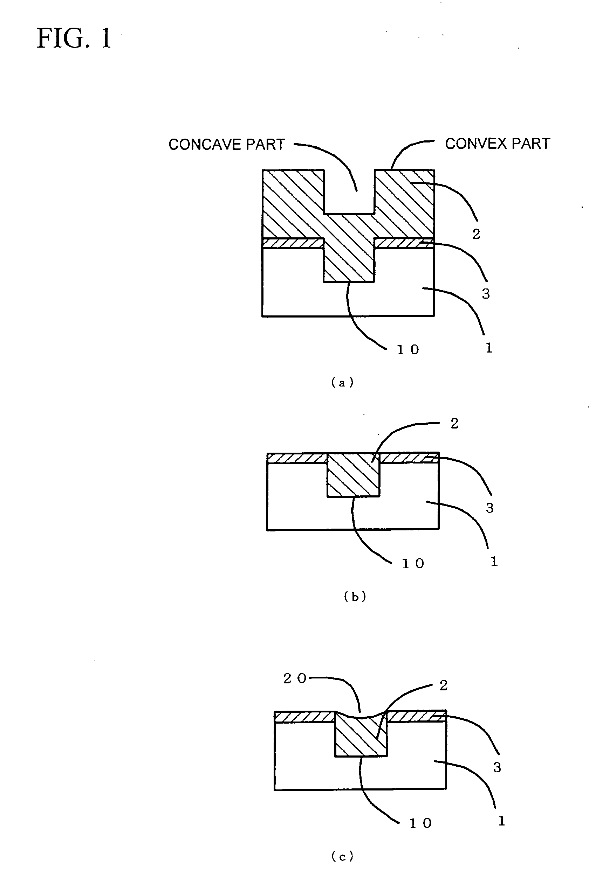

Using Fig. 1, the STI step is described by way of illustration. Fig. 1(a) shows a state in which a trench 10 is formed on a silicon substrate 1 while masking the element region with a silicon nitride film 3 or the like, and then a silicon oxide film 2 or the like which is a kind of a film comprising silicon dioxide is deposited to fill the trench 10. Thereafter, the superfluous silicon oxide film 2 on the silicon nitride film 3, which forms a convex part, is polished and removed by the CMP, and the insulation film in the trench 10 defining a concave part is allowed to remain. The STI step is such a method. When performing the CMP, it is general to create a selective ratio between the polishing rate of the silicon oxide film and the polishing rate of the silicon nitride film, and to use the silicon nitride film 3 as a stopper so that polishing terminates when the silicon nitride film 3 is exposed as shown in Fig. 1(b).

Here, if the polishing is carried out excessively, as shown in Fig. 1(c), the silicon oxide film embedded in the trench part 10 is polished and dented to generate a structural defect called dishing, such as dent 20, and there have been the cases where the planarization may become insufficient or the electrical performance may be deteriorated. The degree of dishing depends on the trench width, and in particular, a trench with a wide width tends to allow great dishing.

The polishing abrasive grain generally used for CMP is heretofore a silica abrasive grain, but this abrasive grain provides a small selective ratio between the polishing rate of the silicon oxide film and the polishing rate of the silicon nitride film. Therefore, in the STI step, a cerium oxide abrasive grain excellent in the polishing selectivity between these films has become to be employed.

Patent Document 1 discloses a planarization technique of preferentially polishing a convex part relative to a concave part by using a polishing agent containing a cerium oxide abrasive grain and, as an additive, an organic compound having a hydrophilic group composed of a carboxyl group or a salt of carboxyl group. The additive as used herein is an additive for improving the trench width dependency of dishing, and in order to reduce the dishing even with a wide trench, the concentration of the above-mentioned additive needs to be high. However, if the additive concentration is made high, aggregation of the cerium oxide abrasive grain is promoted to cause sedimentation of the abrasive grain and deteriorate the dispersion stability of the polishing agent. Also, there is a problem that when aggregation of the abrasive grain occurs, the number of scratches increases and the device becomes defective.

For example, Patent Document 1 discloses an Example of a polishing solution containing, in pure water, 1% of cerium oxide as the abrasive grain and 6.0% of ammonium polycarboxylate as the additive, based on the entire mass of the polishing solution. However, due to high concentration of the additive, severe aggregation of the abrasive grain occurs and when the polishing solution is left to stand, the cerium oxide abrasive grain completely settles out within several minutes. The polishing step by the CMP includes a waiting time of not performing polishing. Therefore, sedimentation of the abrasive grain may be generated in a portion where the polishing agent is not always stirred or flowed, giving rise to clogging of a piping component.

For solving this problem, there is a method of mixing the additive to the polishing agent in piping immediately before a polishing pad or on the polishing pad, but insufficient mixing or non-uniform concentration is readily incurred and the polishing characteristics are liable to become unstable. Also, there is a problem that since the abrasive grain becomes likely to aggregate or attach on the pad, the number of scratches increases.

The cerium oxide abrasive grain is excellent in the polishing characteristics as compared with the conventional silica abrasive grain but readily undergoes sedimentation due to its large specific gravity. Furthermore, there is a serious problem that when the additive is added in excess for improving the polishing characteristics, aggregation is accelerated, and significant aggregation/sedimentation occurs.

Patent Document 2 discloses a polishing agent applicable to shallow trench isolation, which is a polishing agent containing a cerium oxide particle, water and an anionic surfactant, and discloses that the polishing agent is preferably within the regional range surrounded by four points of point A (5.5, 0.9), point B (5.5, 3.0), point C (10.0, 3.0) and point D (9.0, 0.9) when represented on the (x,y) coordinates wherein the pH is x and the viscosity is y. Furthermore, it is disclosed that for realizing global planarization, the addition amount of the surfactant and the pH each needs to be adjusted to the ranges which enables to provide a polishing property wherein the polishing rate of the concave part of a pattern is sufficiently smaller than the polishing rate of the convex part, and that the viscosity of the polishing agent is preferably from 1.0 to 2.5 mPa·s, more preferably from 1.0 to 1.4 mPa·s.

Further, it is disclosed that since the viscosity increases as the addition amount of the surfactant is increased, in order to realize planarization characteristics with less pattern dependency with adjusting the viscosity to a range of 1.0 to 1.4 mPa·s, the pH of the polishing agent after adding the surfactant is preferably from 5.5 to 9, more preferably from 6 to 8.5, and that within the pH range above, the selective ratio between the polishing rate of the silicon oxide film and the polishing rate of the silicon nitride film can be made large. Furthermore, a case of previously adding a slight amount of a dispersant to the abrasive grain is illustrated by an example.

However, when a polishing agent is produced according to an Example of this publication, by the addition of a surfactant to a liquid in which an abrasive grain is dispersed, aggregation occurs to give an average particle diameter as large as 2 to 3 times the average particle diameter of the abrasive grain dispersion. Therefore, the abrasive grain in the polishing agent had poor dispersibility and settled out within several minutes. Thus, there was a difficulty in use and the polishing rate was insufficient. Also, although small dishing variation and excellent planarization characteristics are attained in the case of a high surfactant concentration, but a polishing agent based on an Example with a lower surfactant concentration resulted in a large dishing variation and unsatisfactory planarization characteristics.

Furthermore, rise in the surfactant concentration incurred a rapid increase in the number of scratches. This is attributable to that the aggregation and sedimentation of the cerium oxide abrasive grain are promoted if the surfactant concentration is high. It is considered such that when even a slight amount of coarse particles, which are responsible for scratches, are present in the polishing abrasive grain, the coarse particles accumulate on the polishing pad through aggregation, thereby serving as a cause of increased scratches. In addition, it is considered that the polishing abrasive grain itself after giant grain growth through aggregation may cause a scratch.

As described above, in conventional techniques, a polishing agent satisfying dispersion stability and excellent scratch characteristics of the polishing agent and, at the same time, satisfying excellent planarization characteristics in polishing has not been obtained. Thus, it has been difficult to obtain a semiconductor device having satisfactory characteristics.

| | |
|---|---|
| Patent Document 1: | Japanese Patent No. 3,278,532 (claims) |
| Patent Document 2: | JP-A-2000-160137 (claims) |
| Patent Document 3: | JP-A-11-12561 (claims) |
| Patent Document 4: | JP-A-2001-35818 (claims) |

### DISCLOSURE OF THE INVENTION

### PROBLEMS THAT THE INVENTION IS TO SOLVE

Accordingly, an object of the present invention is to solve the foregoing problems and provide a polishing agent for a semiconductor, which is excellent in the dispersion stability and produces less defects such as scratch and has excellent planarization characteristics in polishing.

### MEANS FOR SOLVING THE PROBLEMS

Embodiment 1 of the present invention provides a polishing agent, which is a polishing agent for chemical mechanical polishing for polishing a to-be-polished surface in a production of a semiconductor integrated circuit device, the polishing agent comprising a cerium oxide particle, a water-soluble polyether amine, at least one substance selected from the group consisting of a polyacrylic acid and a salt thereof, and water, wherein the polishing agent has a pH of from 6 to 9, and wherein the substance is contained in an amount of more than 0.02 mass% based on the entire mass of the polishing agent.

Embodiment 2 provides the polishing agent as described in embodiment 1, wherein the water-soluble polyether amine has a weight average molecular weight of 100 to 2,000 and is contained in the range of 0.001 to 20 mass% based on the entire mass of the polishing agent.

Embodiment 3 provides the polishing agent as described in embodiment 1 or 2, wherein the weight average molecular weight of the polyacrylic acid moiety of the substance is from 1,000 to 1,000,000, and the substance is contained in the range from more than 0.02 mass% to 0.5 mass% or less based on the entire mass of the polishing agent.

Embodiment 4 provides the polishing agent as described in any one of embodiments 1 to 3, wherein the cerium oxide particle is contained in the range of 0.1 to 5 mass% based on the entire mass of the polishing agent.

Embodiment 5 provides a method for polishing a to-be-polished surface, comprising supplying a polishing agent to a polishing pad, bringing the to-be-polished surface of a semiconductor integrated circuit device into contact with the polishing pad, and performing the polishing by means of relative movement between the two members, wherein the to-be-polished surface is a to-be-polished surface of a silicon dioxide-based material layer, and wherein the polishing agent is the polishing agent described in any one of embodiments 1 to 4.

Embodiment 6 provides the polishing method as described in embodiment 5, wherein the silicon dioxide-based material layer is a borophosphosilicate glass (BPSG) layer, a borosilicate glass (BSG) layer or a phosphosilicate glass (PSG) layer.

Embodiment 7 provides the polishing method as described in embodiment 6, wherein the silicon dioxide-based material has a concentration of either phosphorus or boron or each of phosphorus and boron in the range of 0.1 to 20 mass%.

Embodiment 8 provides the polishing method as described in embodiment 5, wherein the silicon dioxide-based material layer is a silicon dioxide layer.

Embodiment 9 provides a method for producing a semiconductor integrated circuit device, comprising a step of polishing a to-be-polished surface by the polishing method described in embodiment 8.

### ADVANTAGE OF THE INVENTION

According to the present invention, a polishing agent which is excellent in the dispersion stability, produces less defects such as scratch and has excellent planarization characteristics in polishing can be obtained.

### BRIEF DESCRIPTION OF THE DRAWINGS

Figs. 1 are schematic side cross-sectional views of a semiconductor device in polishing the semiconductor device.
Fig. 2 is a view showing one example of the polishing apparatus applicable to the polishing method of the present invention.
Fig. 3 is a schematic side cross-sectional view of a wafer with pattern.

### DESCRIPTION OF REFERENCE NUMERALS AND SIGNS

- 1: Silicon substrate
- 2: Silicon oxide film
- 3: Silicon nitride film
- 10: Trench
- 20: Dent
- 31: Semiconductor device
- 32: Polishing head
- 33: Polishing platen
- 34: Polishing pad
- 35: Polishing agent supply piping
- 36: Polishing agent
- 51: Trench of silicon wafer

### BEST MODE FOR CARRYING OUT THE INVENTION

The embodiments of the present invention are described below by using drawings, tables, formulae, working examples and the like. Incidentally, these drawings, tables, formulae, working examples and the like as well as description based thereon are only for illustrating the present invention and should not be construed as limiting the scope of the present invention. As long as the purport of the present invention is observed, other embodiments may belong to the category of the present invention. In the figures, identical numerals indicate identical elements.

The polishing agent of the present invention is a polishing agent for chemical mechanical polishing for polishing a to-be-polished surface of a semiconductor integrated circuit device (hereinafter sometimes simply referred to as a "semiconductor device"), the polishing agent comprising a cerium oxide particle, a water-soluble polyether amine, at least one substance selected from the group consisting of a polyacrylic acid and a salt thereof, and water, wherein the pH of the polishing agent is from 6 to 9 and the substance above is contained in an amount of more than 0.02 mass% based on the entire mass of the polishing agent. A dispersant may be allowed to coexist. Incidentally, the "to-be-polished surface" as used in the present invention means a surface in an intermediate stage, appearing in the course of producing a semiconductor device.

In a production step of a semiconductor device containing a silicon dioxide-based material layer, when this polishing agent is used to polish a to-be-polished surface of the silicon dioxide-based material layer a layer being reduced in defects such as scratch and having a flat surface can be easily formed in a short time. Two or more silicon dioxide-based material layers may be contained in one semiconductor device. The polishing agent is excellent also in dispersion stability.

In the present invention, cerium oxide is used as the polishing abrasive grain in the polishing agent. Conventionally, in regard to the polishing of a silicon dioxide-based material, a cerium oxide abrasive grain has been known to exhibit a peculiarly high polishing rate. This is because, when cerium oxide contacts with the Si-O moiety on the surface of a film to be polished, chemical bonding is produced therebetween to generate a grinding force greater than mere mechanical function. Accordingly, in the polishing using cerium oxide, control of the contact between the abrasive grain and the polishing object is important.

The cerium oxide abrasive grain for use in the present invention is not particularly limited but, for example, the cerium oxide abrasive grains disclosed in Patent Document 3 or 4 may be preferably used. That is, a cerium oxide powder obtained by adding an alkali to an aqueous ammonium cerium(IV) nitrate solution to produce a cerium hydroxide gel and subjecting the gel to filtration, washing and firing can be preferably used. Furthermore, a cerium oxide abrasive grain obtained by grinding high-purity cerium carbonate, followed by firing, pulverization and classification may also be preferably used.

From the aspects of polishing characteristics and dispersion stability, the average particle size (diameter) of the cerium oxide abrasive grain is preferably from 0.01 to 0.5 µm, more preferably from 0.02 to 0.3 µm, still more preferably from 0.05 to 0.2 µm. If the average particle diameter is excessively large, there is a concern that polishing flaws such as scratch may be readily generated on the semiconductor substrate surface, whereas if the average particle diameter is too small, there is a concern that the polishing rate may decrease. Also, if the average particle diameter is too small, the proportion of the surface area per unit volume becomes large, and the abrasive grain is likely to be affected by its surface state. Therefore, depending on the conditions such as pH or additive concentration, there are cases where the abrasive grain readily undergoes aggregation. When aggregation is caused, a polishing defect such as scratch is liable to be generated on the semiconductor substrate surface.

The ratio of the cerium oxide abrasive grain to the entire mass of the polishing agent is preferably from 0.1 to 5 mass%. If the ratio is less than 0.1 mass%, a sufficiently high polishing rate may not be obtained, whereas if it exceeds 5 mass%, it becomes often the case that the polishing agent comes to have an increased viscosity and the handling thereof becomes difficult.

The silicon dioxide-based material for use in the present invention is generally silicon dioxide itself or a material containing other elements in the silicon dioxide. In this case, "containing" means to uniformly contain other elements. As for "other elements" here, an arbitrary element may be used. Examples thereof include boron, phosphorus, carbon, nitrogen and fluorine.

In the case where the silicon dioxide-based material for use in the present invention contains at least either one of boron and phosphorus, the polishing rate greatly differs depending on the concentration of the element contained, and this makes it easy to successfully bring out the effects of the present invention. As for the silicon dioxide-based material containing phosphorus or boron or containing phosphorus and boron, the effects are great when the concentration of phosphorus, boron, or each of phosphorus and boron in the silicon dioxide-based material is in the range of 0.1 to 20 mass%. The silicon dioxide-based material containing phosphorus or boron or containing phosphorus and boron can be formed according to SiO₂-CVD (chemical vapor deposition method) by simultaneously adding SiH₄ (silane), O₂ and an inorganic gas such as B₂H₆ (diborane) and PH₃ (phosphine) or an organic gas such as B(OCH₃)₃ (trimethoxyborane) and P(OCH₃)₃ (trimethoxyphosphine), to a raw material gas.

The material well-known as a silicon dioxide-based material containing phosphorus or boron or containing phosphorus and boron includes borophosphosilicate glass (BPSG), borosilicate glass (BSG) and phosphosilicate glass (PSG). The effect of realizing high planarization of unevenness on a to-be-polished surface with a small polishing amount is considered to be attributable to an adsorption effect of the water-soluble polyether amine to the cerium oxide abrasive grain surface and the to-be-polished surface. Specifically, it is considered that when the water-soluble polyether amine is adsorbed, in the concave part where the polishing pressure is low, a chemical reaction due to contact of cerium oxide with the Si-O moiety in the to-be-polished film is inhibited and the progress of polishing is thereby retarded, whereas in the convex part where the polishing pressure is high, the adsorbed water-soluble polyether amine readily falls off and the polishing preferentially proceeds. As a result, high planarization of the to-be-polished surface can be achieved. In the case of using a water-soluble polyether amine, even when high planarization of a to-be-polished surface can be achieved with a small polishing amount, there might be concerns of causing problems that the time necessary for realizing the high planarization is prolonged or that the dispersibility of the cerium oxide particle in the polishing agent is deteriorated. However, such problems can be overcome by the selection of the pH range and the coexistence of the at least one substance selected from a polyacrylic acid and a salt thereof according to the present invention.

Incidentally, BPSG is a glass containing silicon, phosphorus, boron and oxygen as main components. The contents of phosphorus and boron each can be varied in the range of 0.1 to 20 mass%. BSG is a glass containing silicon, boron and oxygen as main components. The boron content can be varied in the range of 0.1 to 20 mass%. Also, PSG is a glass containing silicon, phosphorus and oxygen as main components. The phosphorus content can be varied in the range of 0.1 to 20 mass%.

The water-soluble polyether amine in the polishing agent is not particularly limited and may be appropriately selected from known compounds. The water solubility may be in any level as long as the compound when observed with an eye is in a state of being completely dissolved in the polishing agent solution at the concentration in use as a polishing agent.

The molecular weight of the water-soluble polyether amine is not particularly limited as long as it is a molecular weight within the range having water solubility, but the molecular weight is preferably from 100 to 2,000 in terms of weight average molecular weight. If the weight average molecular weight is less than 100, the effect is small, whereas if it exceeds 2,000, the solubility in pure water decreases in many cases. From the standpoint of enhancing dispersion stability of the cerium oxide abrasive grain, the weight average molecular weight of the water-soluble polyether amine is more preferably from 150 to 800, still more preferably from 150 to 400.

The polyether amine means a compound having two or more amino groups and two or more etheric oxygen atoms. The amino group is preferably a primary amino group (-NH₂). A secondary amino group (-NH-) or a tertiary amino group may be present, but the polyether amine for use in the present invention is preferably a compound having two or more primary amino groups and having substantially no other amino group, more preferably a polyether diamine having only two primary amino groups. The polyether amine is preferably a compound having a structure where the hydrogen atom of the hydroxyl group in a polyhydric alcohol or polyether polyol is replaced by an aminoalkyl group. The polyhydric alcohol is preferably a di- to hexahydric alcohol, more preferably a dihydric alcohol, and the polyether polyol is preferably a di- to hexa-valent polyoxyalkylene polyol, more preferably a polyoxyalkylene diol. The aminoalkyl group is preferably an aminoalkyl group having from 2 to 6 carbon atoms, such as 2-aminoethyl group, 2-aminopropyl group, 2-amino-1-methylethyl group, 3-aminopropyl group, 2-amino-1,1-dimethylethyl group and 4-aminobutyl group.

The polyhydric alcohol is preferably a dihydric alcohol having from 2 to 8 carbon atoms, which may have an etheric oxygen atom, such as ethylene glycol, diethylene glycol, propylene glycol, and dipropylene glycol. The polyether polyol is preferably a polyether diol with the repeating unit being an oxyalkylene group having from 2 to 6 carbon atoms, for example, a polyethylene glycol (i.e., polyoxyethylene diol) such as triethylene glycol and tetraethylene glycol, a polypropylene glycol (i.e., polyoxypropylene diol) such as tripropylene glycol and tetrapropylene glycol, or a polyoxyalkylene diol having two or more oxyalkylene groups, such as poly(oxypropylene·oxyethylene)diol.

The polyether diamine is preferably a compound having a structure represented by the following formula (1):

H₂N-(R-X-)ₖ-R-NH₂ (1)

wherein R represents an alkylene group having from 2 to 8 carbon atoms, X represents an oxygen atom, and k represents an integer of 2 or more. The plurality of R's within one molecule may be different from one another.

The polyether diamine is more preferably a compound having a structure represented by the following formula (2):

H₂N-R²-O-(R¹-O-)ₘ-R²-NH₂ (2)

wherein R¹ represents an ethylene group or a propylene group, R² represents an alkylene group having from 2 to 6 carbon atoms, m represents an integer of 1 or more, and R¹ and R² may be the same or different.
Specific examples of the polyether diamine represented by formula (2) include a polyoxypropylene diamine (a compound where R¹ and R² are a propylene group and m is an integer of 1 or more), a polyoxyethylene diamine (a compound where R¹ and R² are an ethylene group and m is an integer of 1 or more), a 4,7,10-trioxa-tridecane-1,13-diamine (a compound where R¹ is an ethylene group, R² is a trimethylene group and m is an integer of 2).

By virtue of incorporating the water-soluble polyether amine into the polishing agent, a silicon dioxide-based material layer can be polished by controlling the polishing rate of the silicon dioxide-based material layer to preferentially polish the convex part while retarding the progress of polishing of the concave part, so that polishing to high planarization can be achieved with considerably small pattern dependency.

From the standpoint of obtaining a sufficiently high effect in the control above of the polishing rate, the concentration of the water-soluble polyether amine in the polishing agent is from 0.001 to 20 mass%, and an appropriate concentration is preferably set by taking into consideration the polishing rate, the uniformity of the polishing agent mixture, the weight average molecular weight of the water-soluble polyether amine, and the like. The concentration of the water-soluble polyether amine in the polishing agent is preferably from 0.03 to 5 mass%, more preferably from 0.05 to 3 mass%.

Examples of the at least one substance selected from a polyacrylic acid and a salt thereof, which is used in the present invention, include a polyacrylic acid and an ammonium salt, amine salt or metal salt (e.g., alkali metal salt, alkaline earth salt) thereof. A polyacrylic acid and an ammonium salt thereof are preferred. It may be a mixture. The salt of polyacrylic acid can function as a dispersant for cerium oxide.

In any case, the weight average molecular weight of the polyacrylic acid moiety of this substance is preferably from 1,000 to 1,000,000. If the weight average molecular weight is less than 1,000, such a substance is hardly available in general, whereas if it exceeds 1,000,000, the viscosity rises and the handling thereof becomes difficult.

It is important that the proportion of the substance above in the polishing agent of the present invention is more than 0.02 mass%. If the ratio is 0.02 mass% or less, dispersibility of the abrasive grain is insufficient. The above-described substance is preferably contained in the range from more than 0.02 mass% to 0.5 mass% or less based on the entire mass of the polishing agent. If the ratio exceeds 0.5 mass%, there is a concern that aggregation of the abrasive grain may proceed. Insufficient dispersibility or progress of aggregation of the abrasive grain causes generation of defects such as scratch upon polishing. Incidentally, there are cases where the above-described substance can be used also as an agent having other functions, such as dispersant for the abrasive grain. However, the amount of the "agent having other functions" in such cases is of course included in the proportion of the above-described substance in the polishing agent of the present invention. For example, in the case where 0.005 mass% of an ammonium polyacrylate as the dispersant for the abrasive grain is added to the polishing agent of the present invention and 0.02 mass% of a polyacrylic acid is further added to fulfill the function as the above-described substance, the proportion of the above-described substance in the polishing agent of the present invention is 0.025 mass%.

Water for use in the present invention is not particularly limited, but pure water, ultrapure water, ion-exchanged water or the like may be preferably used in view of effect on other agents, incorporation of impurities and effect on pH.

The polishing agent of the present invention is used at a pH of 6 to 9 in consideration of the polishing characteristics and dispersion stability of the polishing agent. If the pH is less than 6, there is a concern that dispersibility may decrease, whereas if it exceeds 9, the polishing rate in terms of the entire to-be-polished surface is very likely to decrease.

In the polishing agent of the present invention, other components may be allowed to coexist. The other component is typically a dispersant. The dispersant includes a water-soluble organic polymer or an anionic surfactant. As for the water-soluble organic polymer, a polymer having, for example, a carboxylic acid group or an ammonium carboxylate is preferred.

The polishing agent of the present invention need not be necessarily supplied to the polishing site in the form that all the constituent polishing materials are previously mixed. That is, the polishing materials may be mixed at the time of supply to the polishing site to complete the composition of the polishing agent. For example, the composition may be divided into a solution 1 containing a cerium oxide particle, water and optionally a dispersant, and a solution 2 containing a water-soluble polyether amine and the like, and these solutions may be used with appropriately adjusting the mixing ratio at the time of polishing. This is a useful method when the polishing rate needs to be adjusted according to the concentration of boron or phosphorus in the silicon dioxide-based material layer.

In the case of polishing a semiconductor substrate by using the polishing agent of the present invention, the polishing agent is supplied to a polishing pad, the to-be-polished surface of the semiconductor device is brought into contact with the polishing pad, and the to-be-polished surface of the silicon dioxide-based material layer is polished by means of relative movement between the two members. The conditions about the silicon dioxide-based material are the same as those described above in relation to the polishing agent of the present invention.

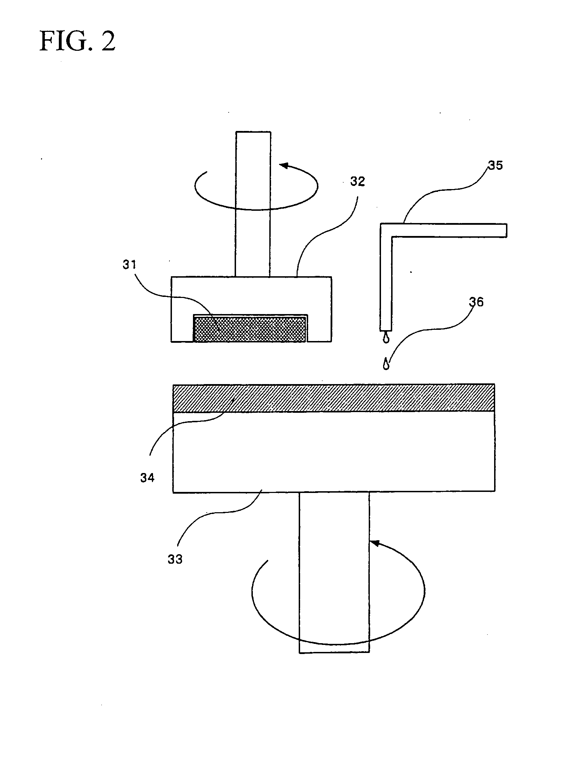

As for the polishing apparatus, a general polishing apparatus can be used. Fig. 2 shows one example of the polishing apparatus applicable to the polishing method of the present invention. This is a system in which while supplying a polishing agent 36 from polishing agent supply piping 35, a semiconductor device 31 is held on a polishing head 32 and brought into contact with a polishing pad 34 attached to the surface of a polishing platen 33 and at the same time, the polishing head 32 and the polishing platen 33 are rotated to make a relative movement. However, the polishing apparatus for use in the present invention is not limited thereto.

The polishing head 32 may make not only rotation but also linear motion. The polishing platen 33 and the polishing pad 34 each may have a size equal to or smaller than the size of the semiconductor device 31. In this case, it is preferred that the polishing head 32 and the polishing platen 33 are moved relatively so that the entire surface of the semiconductor device can be polished. Also, the polishing platen 33 and the polishing pad 34 may not employ a rotary system but each may be moved in one direction, for example, by a belt system.

The polishing conditions of the polishing apparatus are not particularly limited, but the polishing rate can be increased by pressing the polishing head 32 against the polishing pad 34 while applying a load. At this time, the polishing pressure is preferably about 0.5 to 50 kPa and, in view of uniformity of the polishing rate in the semiconductor device, planarity and prevention of polishing defect such as scratch, more preferably about 3 to 40 kPa. The rotation frequency of each of the polishing platen and polishing head is preferably on the order of 50 to 500 rpm, but is not limited thereto.

As for the polishing pad, a general polishing pad formed of non-woven fabric, foamed polyurethane, porous resin, non-porous resin or the like may be used. Also, a grooving work, for example, in a grid, concentric or spiral form may be made on the surface of the polishing pad so as to promote the supply of the polishing agent or to allow a given amount of the polishing agent to stay.

In this way, by the polishing using the polishing agent of the present invention, high planarization of unevenness on the to-be-polished surface of a silicon dioxide-based material layer can be realized in a short time with a small polishing amount. The surface after polishing is very flat, and the remaining film thickness can be easily made large. The polished surface also has less polishing defects, so that the cost for film formation can be reduced and the throughput of film formation can be improved. Accordingly, in the production of a semiconductor device where the polishing method of the present invention is used, the cost can be reduced and the throughput can be improved. The present invention can be suitably used particularly for a semiconductor device employing ILD, STI or PMD.

### EXAMPLES

Examples of the present invention will be illustrated below. Examples 1, 2, 3 and 11 are Invention Examples and others are Comparative Examples. In Examples and Comparative Examples, unless otherwise indicated, "%" means "mass%". The characteristic values were evaluated by the following methods.

### (pH)

The pH was measured by pH81-11 manufactured by Yokogawa Electric Corporation.

### (Average Particle Diameter of Abrasive Grain)

The average particle diameter was determined by using a laser scattering·diffraction apparatus (LA-920, trade name, manufactured by Horiba, Ltd.).

### (Dispersion Stability of Polishing Agent)

The "coagulation time" in Examples was determined, after placing 20 mL of the polishing agent into a glass-made test tube of 18 mm in diameter and standing it for 10 days, as the time until separation into two layers occurred to produce a supernatant.

### (Polishing Characteristics)

### (1) Polishing Conditions

Polishing was performed using the following apparatus and conditions. Polishing machine: full-automatic CMP apparatus MIRRA (manufactured by APPLIED MATERIALS)
Polishing agent supply rate: 200 ml/min
Polishing pad: two-layer pad IC-1400 with K-groove or single-layer pad IC-1000 with K-groove (manufactured by Rodel).
Conditioning of polishing pad: MEC100-PH3.5L (manufactured by Mitsubishi Materials Corp.)
Rotation frequency of polishing platen: 127 rpm
Rotation frequency of Polishing head: 129 rpm
Polishing pressure: 27.6 kPa (in the case of the polishing agents of Examples 1, 2, 4, 5 and 9)

### (2) Evaluation

### Measurement of polishing rate:

A film thickness meter, UV-1280SE (manufactured by KLA-Tencor), was used. Measurement of defect after polishing:
The number of defects such as scratch in the polished wafer plane was measured by using a defect inspection apparatus, KLA-2132 (manufactured by KLA-Tencor).

### (3) Material to be Polished

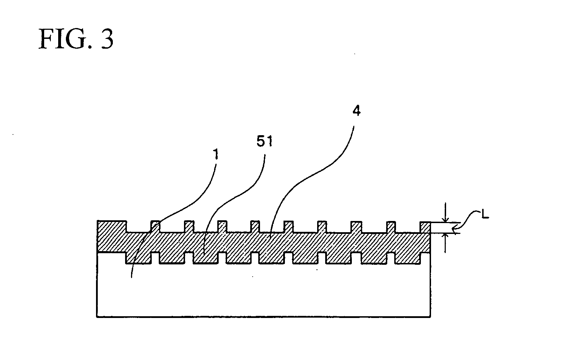

In measuring the variation in film thickness of the convex part to evaluate the planarization achieved by polishing, a wafer with pattern obtained by forming SiO₂ (HDP-SiO₂ film, film thickness: 0.8 µm) by high-density plasma CVD method on a pattern wafer of Model STI864CMP000 produced by International SEMATECH was used. This wafer with pattern has a stripe pattern simulating an STI pattern, in which the pattern width is from 0.5 to 500 µm, the pattern pitch is 100 µm and the pattern density is from 10 to 90%, and the pattern groove on the silicon surface is entirely covered. Fig. 3 shows a schematic side cross-sectional view of the wafer with pattern. Numeral 51 denotes a trench of the silicon wafer.

The variation in film thickness of the convex part after polishing is the difference in film thickness between a portion with a sparse pattern density in which polishing readily proceeds, and a dense portion in which polishing hardly proceeds. Therefore, smaller variation in film thickness of the convex part indicates that the difference in level due to pattern density is smaller, namely, the planarization performance is higher.

Incidentally, the difference in level, that is, the pattern trench depth (corresponding to L in Fig. 3), on the surface of the wafer with pattern was 350 nm in all cases, but the present invention is not limited to this numerical value.

With respect to the pattern wafer, for respective portions having a pattern density of 20 to 90% within one chip, the film thickness of the convex part in the center part of the pattern of each pattern density was measured at one point, and the film thickness of the convex part at each pattern density was determined. The variation in film thickness of the convex part is the difference between the maximum value and the minimum value of the film thickness difference among convex parts with respective pattern densities within one chip. For the measurement of the film thickness, an optical interference-type full-automatic film thickness measuring apparatus, UV1280SE (manufactured by KLA-Tencor), was used.

Incidentally, the numerical value of the pattern density indicates, for example, in the case of 10%, that when the pattern wafer is viewed from the direction orthogonal to the surface thereof, the ratio of the pattern width of the convex part to the total of the pattern width of the convex part and the pattern width of the concave part is 10%.

As for the defect after polishing, an Si wafer with PE-TEOS film (an SiO₂ film formed by a plasma CVD method using Tetra-Ethyl-Ortho-Silicate (TEOS) as a raw material) was polished for 60 seconds, washed, dried and then measured by KLA-2132. The number of defects means the total number of defects detected per one sheet of wafer. For obtaining an average value thereof, two sheets of wafer were used for each level.

### [Example 1]

Cerium oxide abrasive grain and ammonium polyacrylate having a polymerization average molecular weight of 5,000 as a dispersant were mixed with stirring in deionized water to give a mass ratio of 100:0.7, and by applying ultrasonic dispersion and filtration, a mixture having an abrasive grain concentration of 10% and a dispersant concentration of 0.07% was produced. This mixture was 5-fold diluted with deionized water to produce Abrasive Grain Mixture A having an abrasive grain concentration of 2% and a dispersant concentration of 0.014%. The pH of Abrasive Grain Mixture A was 7.6, and the average particle diameter of the abrasive grain was 0.19 µm.

Subsequently, polyoxypropylene diamine having a polymerization average molecular weight of 230 (Polyether-Amine, trade name, produced by BASF) as a water-soluble polyether amine and polyacrylic acid having a molecular weight of 5,000 were dissolved in deionized water to produce Additive Solution B1 having a polyoxypropylene diamine concentration of 1.0 mass% and a polyacrylic acid concentration of 0.6 mass%.

Additive Solution B1 and Abrasive Grain Mixture A were mixed with stirring in a mass ratio of 1:1 to produce a polishing agent having the composition and pH shown in Table 1. In each of the Examples, according to the definition of the present invention, both ammonium polyacrylate and polyacrylic acid come under the "at least one substance selected from a polyacrylic acid and a salt thereof for use in the present invention.

### [Example 2]

A polishing agent having the composition and pH shown in Table 1 was produced in the same manner as in Example 1 except that Additive Solution B2 having a polyoxypropylene diamine concentration of 0.6 mass% and a polyacrylic acid concentration of 0.6 mass% was produced and used.

### [Example 3]

A polishing agent having a pH of 9.0 was produced by adding aqueous ammonia as a pH adjusting agent to a polishing agent obtained in the same manner as in Example 1.

### [Example 4]

A polishing agent having the composition and pH shown in Table 1 was produced in the same manner as in Example 1 except that Additive Solution B4 having a polyoxypropylene diamine concentration of 1.0 mass% and not using polyacrylic acid was produced and used.

### [Example 5]

A polishing agent having the composition and pH shown in Table 1 was produced in the same manner as in Example 1 except that Additive Solution B5 not using polyoxypropylene diamine and having a polyacrylic acid concentration of 0.34 mass% was produced and used and aqueous ammonia was added as a pH adjusting agent.

### [Examples 6 to 8]

Polishing agents where the pH was adjusted to the value shown in Table 1 by adding nitric acid as a pH adjusting agent to a polishing agent produced under the same conditions as in Example 4, were produced.

### [Examples 9 and 10]

Polishing agents of Examples 9 and 10 where the pH was adjusted to the value shown in Table 1 by adding ammonia and nitric acid, respectively, as a pH adjusting agent to a polishing agent produced under the same conditions as in Example 1, were produced.

### [Example 11]

Cerium oxide abrasive grain and ammonium polyacrylate having a polymerization average molecular weight of 5,000 as a dispersant were mixed with stirring in deionized water to give a mass ratio of 50:0.35, and by applying ultrasonic dispersion and filtration, a mixture having an abrasive grain concentration of 5.0 mass% and a dispersant concentration of 0.035% was produced. This mixture was 5-fold diluted with deionized water to produce Abrasive Grain Mixture Solution A1 having an abrasive grain concentration of 1.0 mass% and a dispersant concentration of 0.007 mass%.

Solution A1 and the same Additive Solution B2 as in Example 2 were mixed and stirred in a mass ratio of 1:1 in the same manner as in Example 1 to obtain a polishing agent. A pH adjusting agent was not used. The obtained polishing agent had an abrasive grain concentration of 0.5 mass%, a polyoxypropylene diamine concentration of 0.3 mass%, a polyacrylic acid concentration of 0.3 mass%, and a pH of 6.1.

With respect to each of the above Examples, the composition, pH, coagulation time, evaluation results of polishing characteristics, and the like of the polishing agent are shown in Tables 1 and 2. The polishing time was uniformly 150 seconds. The variation in film thickness of the convex part was determined by measuring the film thickness difference among convex parts at respective pattern densities after polishing. However, items on which results are not shown in Table 2 were not evaluated.

**[Table 1]**

| Example | Abrasive Grain Concentration (%) | Water-Soluble Polyether Amine | | | Polyacrylic Acid | | | pH Adjusting Agent | | pH | Coagulation Time |
|---|---|---|---|---|---|---|---|---|---|---|---|
| | | Kind | Molecular Weight | Concentration (%) | Kind | Molecular Weight | Concentration (%) | Nitric Acid | Aqueous Ammonia | | |
| 1 | 1.0 | polyoxypropylene diamine | 230 | 0.5 | polyacrylic acid | 5000 | 0.3 | none | none | 7.5 | >3 days |
| 2 | 1.0 | polyoxypropylene diamine | 230 | 0.3 | polyacrylic acid | 5000 | 0.3 | none | none | 6.2 | >3 days |
| 3 | 1.0 | polyoxypropylene diamine | 230 | 0.5 | polyacrylic acid | 5000 | 0.3 | none | added | 9.0 | >3 days |
| 4 | 1.0 | polyoxypropylene diamine | 230 | 0.5 | none | - | - | none | none | 10.5 | >3 days |
| 5 | 1.0 | none | - | - | polyacrylic acid | 5000 | 0.17 | none | added | 5.0 | >3 days |
| 6 | 1.0 | polyoxypropylene diamine | 230 | 0.5 | none | - | - | added | none | 7.5 | <2 hours |
| 7 | 1.0 | polyoxypropylene diamine | 230 | 0.5 | none | - | - | added | none | 5.0 | <2 hours |
| 8 | 1.0 | polyoxypropylene diamine | 230 | 0.5 | none | - | - | added | none | 9.0 | <3 days |
| 9 | 1.0 | polyoxypropylene diamine | 230 | 0.5 | polyacrylic acid | 5000 | 0.3 | none | added | 10.0 | >3 days |
| 10 | 1.0 | polyoxypropylene diamine | 230 | 0.5 | polyacrylic acid | 5000 | 0.3 | added | none | 5.0 | <2 hours |
| 11 | 0.5 | polyoxypropylene diamine | 230 | 0.3 | polyacrylic acid | 5000 | 0.3 | none | none | 6.1 | >3 days |

| | | | | | | | | | | | |
|---|---|---|---|---|---|---|---|---|---|---|---|
| (1) Abrasive grain: Cerium oxide (particle diameter: 0.19 µm) (2) Dispersant: For each of the systems, 0.007 mass% of ammonium polyacrylate | | | | | | | | | | | |

**[Table 2]**

| Example | Variation in Film Thickness of Convex Part (nm) | Number of Defects (defects/wafer) |
|---|---|---|
| 1 | 54 | 281 |
| 2 | 55 | 477 |
| 3 | | |
| 4 | 165 | 126 |
| 5 | 52 | 1785 |
| 6 | | |
| 7 | | |
| 8 | | |
| 9 | 130 | |
| 10 | | |
| 11 | | 112 |

In Examples 1, 2, 3 and 11, the dispersion stability was good. In Examples 1, 2 and 11, the number of defects could also be kept small. Furthermore, in Examples 1 and 2, the variation in film thickness of the convex part after polishing could also be kept small irrespective of pattern density. In other words, high planarization of unevenness of the to-be-polished surface could be realized in a short time with small pattern dependency and the number of defects such as scratch was small.

On the other hand, in Example 4, the dispersion stability was good, but the variation in film thickness of the convex part was large. It is presumed that this is probably due to a shortage of the amount of the substances according to the present invention.

In Example 5, the dispersion stability was good, but the number of defects increased greatly. It is presumed that this is due to the non-use of a water-soluble polyether amine.

In Examples 6 to 8, the effects of the substance according to the present invention were examined within the pH range according to the present invention. From these results, it is understood that when the substance according to the present invention is not sufficiently present, a decrease in the pH leads to deterioration of the dispersion stability.

The foregoing results reveal that when the requirements of the present invention are satisfied, high planarization of unevenness of a to-be-polished surface can be realized with a small polishing amount in a short time, and that not only the number of defects is small but also the dispersibility of the polishing agent is good.
Meanwhile, it was revealed that if a water-soluble polyether amine is not present, the number of defects increases, and that if the above-described substance is not present or the amount thereof is not large enough, the dispersibility of the polishing agent in the convex part is deteriorated in the case of a low pH, whereas the polishing characteristics (the variation in film thickness in the convex part) are insufficient in the case of a high pH. Incidentally, even when a water-soluble polyether amine was present and the above-described substance was present in a sufficiently large amount, if the pH of the polishing agent was less than 6, the dispersibility of the polishing agent was deteriorated as shown in Example 10, and if it exceeded 9, the polishing characteristics (the variation in film thickness in the convex part) became insufficient as shown in Example 9.

While the present invention has been described in detail and with reference to specific embodiments thereof, it will be apparent to one skilled in the art that various changes and modifications can be made therein without departing from the spirit and scope of the invention.
This application is based on Japanese Patent Application No. 2006-248220 filed on September 13, 2006, the contents of which are incorporated herein by way of reference.

### INDUSTRIAL APPLICABILITY

The present invention can be suitably used for a semiconductor device employing ILD, STI or PMD.

## Claims

1. A polishing agent, which is a polishing agent for chemical mechanical polishing for polishing a to-be-polished surface in a production of a semiconductor integrated circuit device, said polishing agent comprising:
a cerium oxide particle,
a water-soluble polyether amine,
at least one substance selected from the group consisting of a polyacrylic acid and a salt thereof, and
water,
wherein said polishing agent has a pH of from 6 to 9, and
wherein said substance is contained in an amount of more than 0.02 mass% based on the entire mass of said polishing agent.

2. The polishing agent as claimed in claim 1, wherein said water-soluble polyether amine has a weight average molecular weight of from 100 to 2,000 and is contained in the range of 0.001 to 20 mass% based on the entire mass of said polishing agent.

3. The polishing agent as claimed in claim 1 or 2, wherein the weight average molecular weight of the polyacrylic acid moiety of said substance is from 1,000 to 1,000,000, and said substance is contained in the range from more than 0.02 mass% to 0.5 mass% or less based on the entire mass of said polishing agent.

4. The polishing agent as claimed in any one of claims 1 to 3, wherein said cerium oxide particle is contained in the range of 0.1 to 5 mass% based on the entire mass of said polishing agent.

5. A method for polishing a to-be-polished surface, comprising supplying a polishing agent to a polishing pad, bringing the to-be-polished surface of a semiconductor integrated circuit device into contact with the polishing pad, and performing the polishing by means of relative movement between two members,
wherein said to-be-polished surface is a to-be-polished surface of a silicon dioxide-based material layer, and
wherein said polishing agent is the polishing agent claimed in any one of claims 1 to 4.

6. The polishing method as claimed in claim 5, wherein said silicon dioxide-based material layer is a borophosphosilicate glass (BPSG) layer, a borosilicate glass (BSG) layer or a phosphosilicate glass (PSG) layer.

7. The polishing method as claimed in claim 6, wherein said silicon dioxide-based material has a concentration of either phosphorus or boron or each of phosphorus and boron in the range of 0.1 to 20 mass%.

8. The polishing method as claimed in claim 5, wherein said silicon dioxide-based material layer is a silicon dioxide layer.

9. A method for producing a semiconductor integrated circuit device, comprising a step of polishing a to-be-polished surface by the polishing method claimed in claim 8.
